# EUROPEAN PATENT APPLICATION

(11) **EP 1 544 906 A1**
(43) Date of publication of application: **22.06.2005**
(21) Application number: 03771391.4
(22) Date of filing: 28.07.2003
(51) Int. Cl.: H01L 21/3205, H01L 21/822, H01L 27/04, H01L 21/82, C30B 33/08, C30B 29/06

(54) **METHOD AND DEVICE FOR LASER BEAM PROCESSING OF SILICON SUBSTRATE, AND METHOD AND DEVICE FOR LASER BEAM CUTTING OF SILICON WIRING**

(30) Priority: 29.07.2002 JP 2002220036
(71) Applicant: SUMITOMO PRECISION PRODUCTS COMPANY LIMITED, Amagasaki-shi, Hyogo Prefecture 660-0891 (JP)
(72) Inventor: ARAKI, Ryuta Sumitomo Precision Products Co.,Ltd., Amagasaki-shi, Hyogo 660-0891 (JP)
(74) Representative: Uchida, Kenji
(86) International application number: PCT/JP2003/009557
(87) International publication number: WO 2004/012253

(57) **Abstract**

(1) A laser processing method for silicon substrates wherein a roughness (Ra) of a surface of a silicon substrate is adjusted to 0.05 micron - 1 micron after which a laser is applied. (2) A laser processing device for silicon substrates including: means for adjusting a surface of a silicon substrate to 0.05 micron - 1 micron; and means for applying a laser. This method and device is able to prevent spattering of melted silicon and provides superior processing precision and allows efficient formation of holes and cutting on a silicon substrate. In particular, the present invention is useful for opening short-circuit sections disposed in silicon wiring.

## Description

### BACKGROUND OF THE INVENTION

The present invention relates to a laser processing method and device for the same, wherein splattering of molten silicon does not take place during laser processing of silicon substrates used in semiconductor devices.

With the growing compactness of various parts such as transistors and diodes and the growing degree of integration in electronic circuits, the number of parts that are connected in a single semiconductor device has been increasing. In making semiconductor devices containing a large number of parts and making systems in which a large number of these semiconductor devices are connected, there is an increasing degree of complexity in the electronic devices and a corresponding need to provide higher reliability.

For example, a system made from semiconductor devices may use tens of thousands to hundreds of thousands of parts such as transistors and diodes. If a malfunction in even one of these parts were to render the system inoperable, it would not be possible to provide increased reliability and redundancy. Therefore, devices can have built-in means for correcting problems in the entire device caused by malfunctions in individual parts by providing ahead of time multiple redundant circuits with short-circuit sections. This makes it possible to cut off and remove a section where a malfunction took place.

In recent years, semiconductor devices are provided with various option features. Multiple electronic circuits providing similar functions are set up ahead of time so that fine adjustments to capacitance values and resistance values can be made at the production stage.

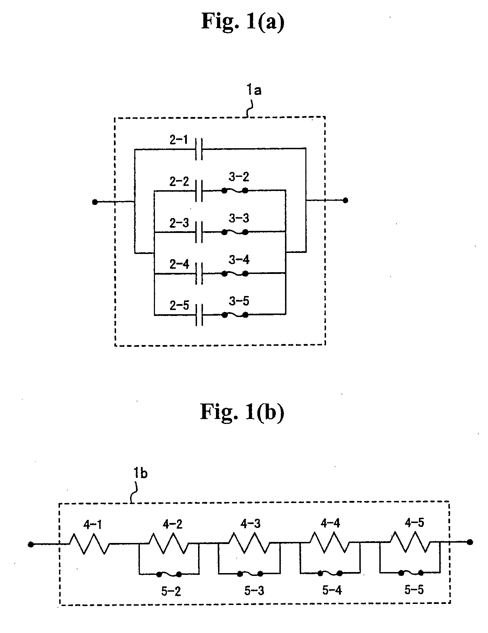

Fig. 1 is a simplified drawing of an example of an electronic circuit in which fine adjustments to device performances can be made. Fig. 1 (a) shows an electronic circuit in which fine adjustments can be made to capacitance. Fig. 1 (b) shows an electronic circuit in which fine adjustments can be made to resistance.

As shown in Fig. 1 (a), in an electronic circuit 1a, a capacitor 2-1 and capacitors 2-2 - 2-5 are connected in parallel, and short-circuit sections 3-2 - 3-5 are disposed at the wiring for the capacitors 2-2 - 2-5. With this structure, opening some or all of the short-circuit sections 3-2 - 3-5 allows fine adjustments of the overall capacitance of the electronic circuit 1a to be made. Also, as shown in Fig. 1 (b), in an electronic circuit 1b, a resistor 4-1 and resistors 4-2 - 4-5 are connected in series, and the resistors 4-2 - 4-5 are connected in parallel to short-circuit sections 5-2 - 5-5. Because of this structure in the electronic circuit 1b, cutting off some or all of the short-circuit sections 5-2 - 5-5 allows fine adjustments of the overall resistance to be made. The opening of the short-circuit sections in these types of electronic circuits is generally performed by applying a laser.

Also, in the MEMS (Micro-Electro-Mechanical Systems) field, which has been the focus of much attention recently, much development and improvement has been taking place in production methods for precision devices. An example of a precision device is a vibrating ring gyroscope, and various improvements have been investigated to improve the reliability of vibrating gyroscopes. The method described in Japanese laid-open patent publication number Hei 11-83498 is one example. In this publication, a laser is used to form a hole at a predetermined position on a ring in a vibrating ring gyroscope, thereby adjusting the mass balance of the ring itself so that the drive status can be adjusted.

In using a laser to cut or form holes in a silicon substrate in this manner, a laser with a high energy density is applied because of the need to melt and vaporize the silicon substrate. For example, when using a YAG laser (wavelength: 532 microns) to cut or form a hole in a silicon substrate, a beam with an energy density of approximately 110,000 J/m² must generally be applied.

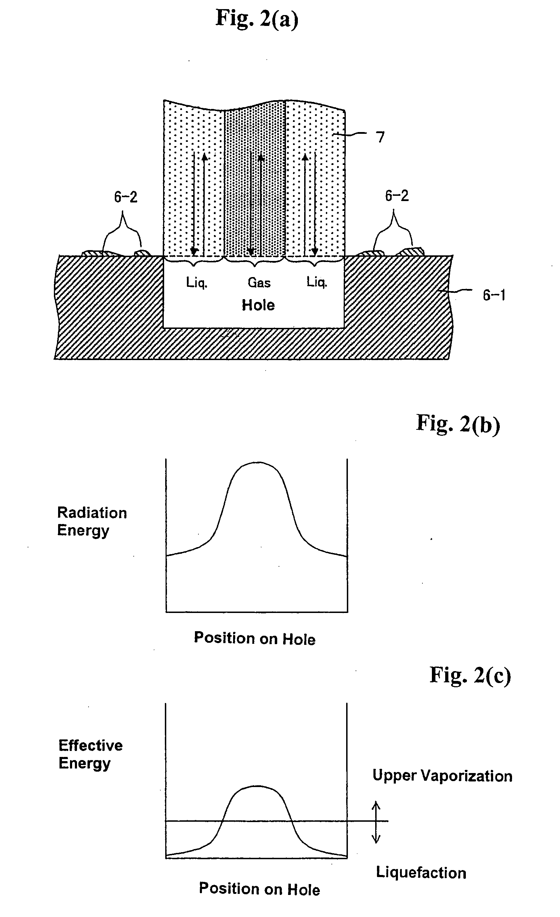

Fig. 2 illustrates the formation of a hole in a mirror surface of a silicon substrate using a laser. Fig. 2 (a) is a simplified cross-section drawing showing the state of the silicon surface when processing takes place. Fig. 2 (b) shows the energy distribution of the laser. Fig. 2 (c) shows the distribution of the effective energy of the laser.

As shown in Fig. 2 (a), when applying a laser beam 7 to the surface of a silicon substrate 6-1 to form a hole, the silicon substrate 6-1 melts and spatters, creating spatterings 6-2. When these spatterings 6-2 are created, they can obstruct the insulation properties of the semiconductor devices and can adhese to nearby parts and lead to malfunctions. As a result, the reliability of the device is significantly decreased.

The present inventor investigated the causes of the spatterings 6-2 shown in Fig. 2 (a) and observed the following.

When a form is holed in the mirror-finished substrate 6-1 with the laser 7, regular reflection of the laser 7 takes place at the surface of the silicon substrate 6-1. Also, as shown in Fig. 2 (b), the energy density of the laser 7 applied to the silicon is generally highest at the center of the direction of travel of the laser 7 and the density decreases away from the center. Thus, as indicated in Fig. 2 (c), even if regular reflection of the laser 7 takes place at the surface of the silicon substrate 6-1, the energy density of the laser 7 is high at the center of the hole being formed, leading to a high effective energy (i.e., the absorption energy effectively contributing to the melting or the vaporizing of the silicon), which results in the silicon substrate 6-1 being vaporized at this section.

However, the energy density of the laser 7 applied to the perimeter area of the hole is low from the start. Thus, when a regular reflection of the laser 7 takes place, the effective energy is low and the silicon substrate 6-1 is liquefied rather than being vaporized. The liquefied silicon around the perimeter area of the hole is spattered around the hole by the pressure from the vaporized silicon near the center.

The present inventor performed similar tests with the position with the highest laser energy density shifted away from the center of the hole toward the perimeter area. It was found that silicon spattered most on the side opposite from the direction in which the position with the highest energy density was shifted. This occurred because the perimeter area on the side away from the direction of the shift of the highest energy density position had more liquefied silicon than the perimeter area of the hole on the side toward the direction of the shift.

### OBJECT AND SUMMARY OF THE INVENTION

The object of the present invention is to provide a laser processing method and device for the same that prevents spattering of melted silicon, that provides superior processing precision, and that allows efficient hole-forming and cutting of a silicon substrate.

The present invention essentially provides a silicon substrate laser processing method described in (1) below and a laser processing device described in (2) below. This processing method and processing device are especially useful in cutting silicon wiring.
(1) A laser processing method for silicon substrates wherein a roughness (Ra) of a surface of a silicon substrate is adjusted to 0.05 micron - 1 micron after which a laser is applied.
(2) A laser processing device for silicon substrates comprising: means for adjusting a surface of a silicon substrate to 0.05 micron - 1 micron; and means for applying a laser.

The above, and other objects, features and advantages of the present invention will become apparent from the following description read in conjunction with the accompanying drawings, in which like reference numerals designate the same elements.

### BRIEF DESCRIPTION OF THE DRAWINGS

Fig. 1 shows simplified drawings of a sample electronic circuit for which fine adjustments of device properties can be made. Fig. 1 (a) is an electronic circuit for which capacitance can be adjusted. Fig. 1 (b) is an electronic circuit for which resistance can be adjusted.
Fig. 2 illustrates the use of a laser to form a hole in mirror-surface silicon. Fig. 2 (a) is a simplified cross-section drawing showing the silicon surface during processing. Fig. 2 (b) shows the distribution of laser radiation energy. Fig. 2 (c) shows the distribution of the effective energy of the laser.

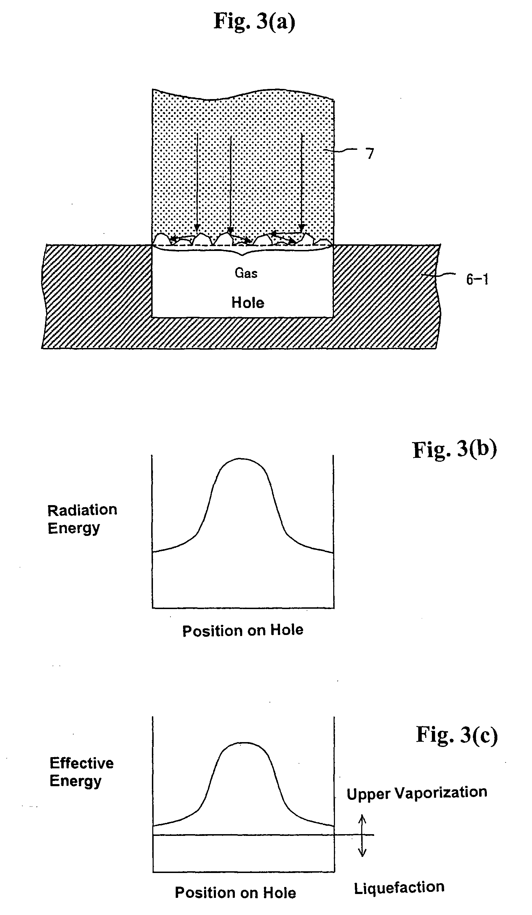

Fig. 3 illustrates the use of the method of the present invention to form a hole in silicon. Fig. 3 (a) is a simplified cross-section drawing showing the silicon surface during processing. Fig. 3 (b) shows the distribution of laser radiation energy. Fig. 3 (c) shows the distribution of the effective energy of the laser.

### DETAILED DESCRIPTION OF THE PREFERRED EMBODIMENTS

Fig. 3 illustrates the forming of a hole in silicon according to the method of the present invention. Fig. 3 (a) is a simplified cross-section drawing showing the surface of the silicon when the process is being performed. Fig. 3 (b) shows the distribution of laser energy. Fig. 3 (c) shows the distribution of effective energy from the laser.

As shown in Fig. 3 (a), in the method of the present invention, a laser 7 is applied to silicon on the surface of which are formed projections and indentations to provide a predetermined roughness. As a result, the hole can be formed without the creation of the spatterings 6-2 formed in Fig. 2 (a) described above. This is because the laser 7 applied to the rough silicon surface undergoes irregular reflection and is absorbed into the silicon more easily. As shown in Fig. 3 (c), while the effective energy of the laser 7 is less than the applied energy, a high level can be maintained overall. As a result, silicon is vaporized not only near the center of the hole but also at the perimeter section, so that the spattering of silicon can be prevented.

The present inventors performed various studies based on the above observations, and based on the results, completed the laser processing method of the present invention, in which projections and indentations of 0.05 micron - 1 micron Ra are formed on the surface of the silicon substrate and a laser is applied.

If the roughness (Ra) formed ahead of time on the silicon substrate surface is less than 0.05 microns, the effective energy of the laser cannot be made high enough over the entire area of the application position, resulting in the silicon at the perimeter section of the hole not being vaporized. This makes it impossible to prevent the spattering of silicon. Thus, the lower limit of the Ra of the silicon substrate surface is set to 0.05 microns. The lower limit is preferably 0.1 micron.

If the roughness (Ra) of the silicon surface exceeds 1 micron, the irregular reflection is inadequate, and the effective energy cannot be kept high. Also, this results in points where the energy absorption rate is high and points where it is low, which makes it impossible to prevent spattering. Thus, the upper limit of the Ra of the silicon substrate surface is set to 1 micron. The upper limit is preferably 0.5 micron.

Thus, in the laser processing method of the present invention, the roughness (Ra) of the silicon substrate surface is adjusted to 0.05 micron - 1 micron, and then a laser is applied. This laser processing method is especially useful when cutting silicon wiring.

The description above presents the processing involved in forming a hole in the silicon substrate, but it would also be possible to cut wiring by applying a laser with a beam diameter greater than the width of the silicon wiring. Alternatively, the laser can be scanned to cut or perform fine processing on the silicon substrate.

Means for adjusting the silicon substrate surface roughness (Ra) to 0.05 micron - 1 micron can include, for example, (1) through (5) below.

### (1) Patterning using photolithography technology

In this method, a resist is applied to a silicon substrate on which an oxide film is formed. The substrate is then developed and rinsed, after which dry etching or wet etching is performed. By performing etching over a shorter time period than generally used makes it possible to form indentations and projections on the silicon substrate surface at a predetermined roughness setting.

### (2) Plasma etching

In this method, a mask opening is formed on the silicon substrate, and C₃F₈ or C₄F₈ plasma is used to form a deposition film on the opening that is non-uniform over a very fine level. This is then exposed to SF₈ plasma. As a result, isotropic etching is begun from the sections with a thinner deposition film, and etching takes place starting from the sections where the deposition film has been removed. Indentations and projections can be formed to a predetermined roughness on the silicon substrate surface by adjusting the diameter of the mask opening, the plasma exposure time, the chamber pressure, the electrical power applied to the substrate, and the like.

### (3) Single-ion beam technology

In this method, a focused silicon ion beam is applied in a localized manner to an oxide film formed on the silicon substrate. Patterning is performed on the oxide film by removing the sections on exposed to the ion beam using 2.5% HF. Then, the oxide film is used as a mask to perform anisotropic etching using hydrazine. Since the sections of the oxide film exposed to the ion beam have a greater etching rate in response to HF, indentations and projections can be formed to a predetermined roughness on the silicon substrate surface by adjusting the conditions of the focused silicon ion beam applied to the oxide film (e.g., acceleration voltage, exposure time).

### (4) Surface grinding technology

In this method, an in-feed grinder is used with wafer rotation to perform surface grinding of a silicon wafer with a diamond wheel. Indentations and projections can be formed to a predetermined roughness on the silicon substrate surface by adjusting spindle speed, grinding time, the count of the diamond wheel, and the like.

### (5) Inkjet system

This method is an application of the pigment discharge method using in inkjet printers. More specifically, inkjet printers print onto paper by discharging a fast-drying solvent such as MEK (methyl ethyl ketone) in which an inorganic pigment such as carbon black is dispersed. Indentations and projections can be formed to a predetermined roughness on the silicon substrate surface by adjusting the particle diameter of the sprayed pigment within a predetermined range.

The laser beam can be applied with a solid-state laser (light source: ruby, YAG (yttrium-aluminum-garnet), glass, alexandrite, or the like), a gas laser (light source: CO₂, CO, Ar ion, or the like), an excimer laser (light source: Ar F, Kr F, XeCl, Xe F, or the like), a metal vapor laser (light source: Cu ion or the like), a dye laser (e.g., a Dye laser), or the like, but it would be preferable to use a YAG laser or a CO₂ laser because of the high output that can be obtained.

For example, a YAG laser and a nonlinear crystal (wavelength: 532 nm) can be used to form a hole with a diameter of approximately 15 microns and a depth of approximately 40 microns. After adjusting the wafer surface roughness using one of the methods described above, a laser can be applied under the conditions described below. As described above, if these conditions are met, good processing efficiency can be maintained, and spattering of melted silicon does not take place even at the laser energy densities used.
Energy density at the silicon wafer surface: 100,000 - 130,000 J/m²
Beam pulse count: 20 - 35

In order to confirm the advantages of the present invention, tests were performed in which a YAG laser and an asymmetrical crystal (wavelength: 532 nm) was used to form holes of approximately 15 micron diameter and 40 micron depth on the samples shown in Table 1. The laser energy density on the silicon wafer surface was 110,000 J/m² and the beam pulse count was 30.

**Table 1**

| No. | Surface Roughness of Silicon Substrate (Ra) | Presence of Spattering |
|---|---|---|
| 1 | 0.01 µm or less | present |
| 2 | 0.02µm | present |
| 3 | 0.05µm | none |
| 4 | 0.11µm | none |
| 5 | 0.47µm | none |
| 6 | 0.84µm | none |
| 7 | 2.00µm | present |

In No. 1, mirror-surface silicon was used. In No. 2 through No. 7, method (2) described above (plasma etching) was performed on mirror-surface silicon. The surface roughness of No. 2 through No. 7 were adjusted by varying the diameter of the mask opening, the plasma exposure time, the chamber pressure, the electrical power applied to the substrate, and the like.

As table 1 shows, in samples No. 3, 4, 5, and 6, which have surface roughnesses (Ra) that are within the scope of the present invention, there was no spattering of melted silicon. On the other hand, in samples No. 1, 2, and 7, which have roughnesses (Ra) that are outside of the scope of the present invention, there was spattering of melted silicon.

When hole is to be formed in or silicon wiring is to be cut on a silicon substrate through the application of a laser, the present invention makes it possible to prevent spattering of melted silicon.

## Claims

1. A method for processing silicon substrates with a laser, comprising the steps of:
- adjusting the surface roughness (Ra) of said silicon substrates to 0.05 µm to 1 µm; and
- applying said laser thereto.

2. A device for processing silicon substrates with a laser, comprising:
- means for adjusting the surface roughness (Ra) of said silicon substrates to 0.05 µm to 1 µm; and
- means for applying said laser thereto.

3. A method for cutting silicon wiring with a laser comprising the steps of:
- adjusting the surface roughness (Ra) of said silicon wiring to 0.05 µm to 1 µm; and
- applying said laser thereto.

4. A device for cutting silicon wiring with a laser, comprising:
- means for adjusting the surface roughness (Ra) of said silicon wiring to 0.05 µm to 1 µm; and
- means for applying said laser thereto.
